(19) **Europäisches Patentamt**
**European Patent Office**
**Office européen des brevets**

(11) Veröffentlichungsnummer : **0 284 843 B1**

(12) # EUROPÄISCHE PATENTSCHRIFT

(45) Veröffentlichungstag der Patentschrift :
05.06.91 Patentblatt 91/23

(51) Int. Cl.⁵ : **H05K 1/00**

(21) Anmeldenummer : 88103632.1

(22) Anmeldetag : 08.03.88

(54) **Rückwandleiterplatte.**

(30) Priorität : 20.03.87 DE 3709115

(43) Veröffentlichungstag der Anmeldung :
05.10.88 Patentblatt 88/40

(45) Bekanntmachung des Hinweises auf die
Patenterteilung :
05.06.91 Patentblatt 91/23

(84) Benannte Vertragsstaaten :
CH DE FR GB LI

(56) Entgegenhaltungen :
EP-A- 0 004 899
EP-A- 0 195 955
DE-A- 2 233 578
DE-U- 8 410 261
FR-A- 2 525 065

(73) Patentinhaber : **Siemens Aktiengesellschaft**
**Wittelsbacherplatz 2**
**W-8000 München 2 (DE)**

(72) Erfinder : **Bremer, Klaus, Dipl.-Ing.**
**Eskilstunastrasse 17**
**W-8520 Erlangen (DE)**

EP 0 284 843 B1

## Beschreibung

Die Erfindung bezieht sich auf eine Rückwandleiterplatte mit mehreren parallel nebeneinander auf der den Baugruppen zugewandten Seite angeordneten Federleisten, deren Kontaktstifte auf der den Baugruppen abgewandten Seite ein Stachelfeld bilden, und mit wenigstens einem Bus, der wenigstens aus einer Busleitung besteht.

Derartige Rückwandleiterplatten sind im Handel erhältlich und beispielsweise als VME-Bus-Leiterplatte bekannt. Dabei ist der VME-Bus ein standardisierter Bus, der für den grundlegenden schnellen Datenverkehr zwischen den wichtigsten Komponenten eines Bussystemes zuständig ist. Dabei bildet die Busstruktur die Verbindungsschienen zwischen den Bausteinen und -gruppen eines Mikro- oder Minicomputersystems. Je nach den verwendeten Systemkomponenten und der geforderten Leistungsfähigkeit variieren auch die Busstrukturen. Da der gesamte Datenaustausch über derartige Bussysteme erfolgt, beeinflußt deren Struktur die Leistungsfähigkeit des Gesamtsystems. Der Datenaustausch erfolgt beispielsweise im 8-, 16- oder 32-Bit-Format, d.h., es sind beispielsweise 8, 16 oder 32 Busleitungssysteme vorgesehen, die die einzelnen Baugruppen eines Bussystems untereinander verbinden. Bei derartigen baugruppenübergreifenden Bussystemen kann ein Fehler, beispielsweise ein Kurzschluß eines Ausgangstreibers mit der Versorgungsspannung eines Busteilnehmers, das gesamte Bussystem blockieren. Eine Lokalisierung des defekten Busteilnehmers ist bei vielen Fehlerarten mit Hilfe einer Diagnoseroutine möglich. Jedoch kann bei einigen Fehlerarten die Störung nur dadurch gefunden werden, daß nacheinander alle Busteilnehmer vom Bus getrennt werden bis der defekte Teilnehmer gefunden und damit die Störung behoben ist. Beim Herausziehen des Busteilnehmers aus seinem Steckplatz in einem Baugruppenträger wird die gesamte Funktion des betroffenen Teilnehmers außer Betrieb gesetzt. Dies bringt erhebliche Einschränkungen der Verfügbarkeit des Systems mit sich.

Der Erfindung liegt nun die Aufgabe zugrunde, eine Rückwandleiterplatte der eingangs genannten Art so weiterzubilden, daß mindestens eine Baugruppe von einem baugruppenübergreifenden Bus abgetrennt werden kann, ohne dabei die Baugruppe selbst aus ihrem Steckplatz eines Baugruppenträgers herausziehen zu müssen.

Diese Aufgabe wird erfindungsgemäß dadurch gelöst, daß einem Buskontaktstift jeder Federleiste eines Busses ein Kontaktstift zugeordnet ist, daß diese Kontaktstifte untereinander mittels der Busleitung elektrisch leitend verbunden sind und daß jeder Kontaktstift mittels eines Brückensteckers mit seinem zugeordneten Buskontaktstift elektrisch leitend verbindbar ist.

Gegenüber der bekannten Rückwandleiterplatte verbinden die Busleitungen eines Busses nicht jeweils die Buskontaktstifte mehrerer Federleisten miteinander, sondern deren korrespondierenden Kontaktstifte, die parallel zu den Buskontaktstiften angeordnet sind. Die Kontaktierung jeweils zwischen den Buskontaktstiften einer Federleiste und den korrespondierenden Kontaktstiften erfolgt mit Hilfe eines Brückensteckers, der jeweils auf die korrespondierenden Kontakte aufsteckbar ist. Durch diese Gestaltung der Rückwandleiterplatte ist es möglich, daß eine defekte Busteilnehmer-Baugruppe vom Bus getrennt werden kann, ohne dabei diese Busteilnehmer-Baugruppe aus seinem Steckplatz eines Baugruppenträger herausziehen zu müssen. Somit kann eine beliebige Busteilnehmer-Baugruppe von einem baugruppenübergreifenden Bus getrennt werden, damit er diesen nicht mehr blockiert, ohne daß dabei die zusätzlichen Funktionen dieser betroffenen Baugruppe außer Betrieb gesetzt werden.

In einer vorteilhaften Ausführungsform ist die Rückwandleiterplatte mit wenigstens zwei Bussen versehen, wobei die Busse jeweils aus mehreren Busleitungen bestehen können und daß die Buskontaktstifte jeder Federleiste eines Busses mittels vielpoliger Brückenstecker mit den korrespondierenden Kontakten verbindbar sind.

Bei wenigstens zwei Bussen auf der Rückwandleiterplatte, wobei die Busse jeweils aus mehreren Busleitungen bestehen, kann einer der beiden Busse als redundanter Bus zum anderen vorgesehen sein. Bei einem solchen redundanten System sind jeweils die Busteilnehmer-Baugruppen mittels vielpoliger Brückenstecker mit beiden Bussen verbindbar. Dadurch wird es möglich, die Baugruppen elektrisch vom Bus zu trennen, ohne die Baugruppe selbst außer Betrieb zu setzen. Damit wird die Möglichkeit zur Fehlerlokalisierung auf einem der beiden Busse ohne Beeinträchtigung der Verfügbarkeit des Systems erreicht.

Zur weiteren Erläuterung der Erfindung wird auf die Zeichnung Bezug genommen, in der ein Ausführungsbeispiel nach der Erfindung schematisch veranschaulicht ist.

FIG 1 zeigt einen Längsschnitt durch eine Rückwandleiterplatte, die mit zwei Bussen versehen ist und die

FIG 2 veranschaulicht eine Draufsicht auf der den Baugruppen abgewandten Seite der Rückwandleiterplatte ohne Brückenstecker.

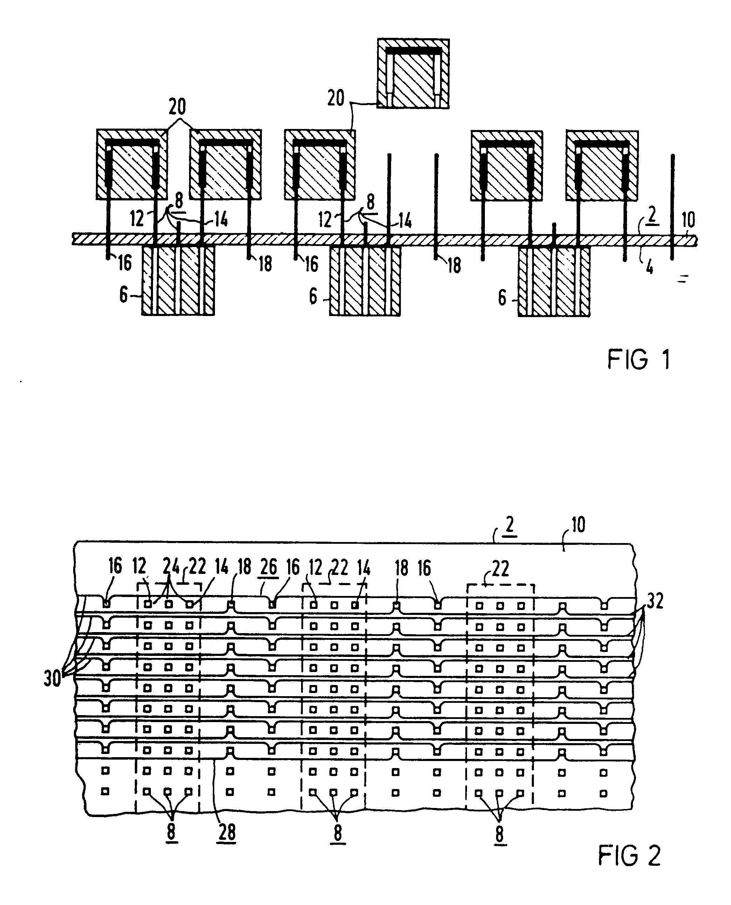

Die FIG 1 zeigt einen Schnitt durch eine Rückwandleiterplatte 2, die auf der den Baugruppen zugewandten Seite 4 mit mehreren Federleisten 6 versehen ist. Die Kontaktstifte 8 der Federleiste 6 bilden auf der den Baugruppen abgewandten Seite 10 ein Stachelfeld. Jedem Buskontaktstift 12 bzw. 14 jeder Federleiste 6 eines Busses ist ein korrespondierender Kontaktstift 16 bzw. 18 zugeordnet. Die korrespondierenden Kontaktstifte 16 bzw. 18 sind jeweils mit einem Brückenstecker 20 mit einem entsprechenden Buskontaktstift 12 bzw. 14 elektrisch leitend verbunden.

Die FIG 2 zeigt eine Draufsicht auf der den Baugruppen abgewandten Seite 10 der Rückwandleiterplatte 2, wobei aus Übersichtlichkeitsgründen auf die Darstellung der Brückenstecker 20 verzichtet wurde. Die Federleiste 6, die auf der den Baugruppen zugewandten Seite 6 angeordnet sind, sind auf der den Baugruppen abgewandten Seite 10 jeweils mittels einer unterbrochenen Linie 22 dargestellt. Als Federleisten 6 sind 96-polige Federleisten vorgesehen, wobei die Kontaktstifte 8 jeweils in drei Kontaktreihen 24 angeordnet sind. Außerdem sind zwei Busse 26 bzw. 28 vorgesehen, die jeweils acht Busleitungen 30 bzw. 32 haben. Dabei ist der Bus 28 redundant zum Bus 26. Die Buskontaktstifte 12 jeder Federleiste 6 des Busses 26 gehören jeweils zu den Kontaktstiften einer äußeren Reihe jeder Federleiste 6. Jedem dieser Buskontaktstifte 12 ist ein Kontaktstift 16 zugeordnet. Diese acht Kontaktstifte 16, die jeweils einer Federleiste 6 zugeordnet sind, sind mittels der acht Busleitungen 30 des ersten Busses 26 miteinander elektrisch leitend verbunden. Mit einem vielpoligen Brückenstecker 20, hier einen achtpoligen Brückenstecker, sind die einzelnen Busteilnehmer-Baugruppen mit dem ersten Bus 26 elektrisch verbunden. Die Buskontaktstifte 14 jeder Federleiste 6 sind ebenfalls mittels achtpoliger Brückenstecker 20 mit den korrespondierenden Kontaktstiften 18 elektrisch leitend verbunden. Dabei sind diese acht Kontaktstifte 18 mittels der acht Busleitungen 32 miteinander elektrisch leitend verbunden.

Im Betriebszustand dieser Rückwandleiterplatte 2 sind alle Busteilnehmer-Baugruppen mit dem Bus 26 und dem redundanten Bus 28 mittels der vielpoligen Brückenstrecker 20 verknüpft. Der Datentransfer zwischen den einzelnen Busteilnehmer-Baugruppen findet beispielsweise auf dem ersten Bus 26 statt. Wenn nun ein Fehler auftritt, so kann auf den redundanten Bus 28 umgeschaltet werden. Damit kann das System in Betrieb bleiben. Die Fehlersuche erfolgt nun auf dem gestörten Bus, indem die Baugruppen vom Bus 26 nacheinander getrennt werden, d.h., nacheinander werden die Brückenkontakte 20 abgezogen, die die Baugruppen mit dem ersten Bus 26 verbinden. Durch eine geeignete Testroutine wird festgestellt, bei welcher Baugruppe die Blockierung des Busses 26 behoben ist. Der so lokalisierte defekte Teilnehmer kann nun ausgetauscht werden.

Somit kann man mit Hilfe der Brückenstecker 20, die die Buskontaktstifte 12 bzw. 14 jeder Federleiste 6 mit den Kontaktstiften 16 bzw. 18 der Busleitungen 30 bzw. 32 elektrisch verbinden, jederzeit eine störende Baugruppe von einem Bus trennen, ohne dabei diese Baugruppen aus ihrem Steckplatz eines Baugruppenträgers herausziehen zu müssen. Dadurch wird die Verfügbarkeit eines Systems vergrößert.

## Ansprüche

1. Rückwandleiterplatte (2) mit mehreren parallel nebeneinander auf der den Baugruppen zugewandten Seite (4) angeordneten Federleisten (6), deren Kontaktstifte (8) auf der den Baugruppen abgewandten Seite (10) ein Stachelfeld bilden, und mit wenigstens einem Bus (26, 28), der wenigstens aus einer Busleitung (30, 32) besteht, **dadurch gekennzeichnet**, daß einem Buskontaktstift (12, 14) jeder Federleiste (6) eines Busses (26, 28) ein Kontaktstift (16, 18) zugeordnet ist, daß diese Kontaktstifte (16, 18) untereinander mittels der Busleitung (30, 32) elektrisch leitend verbunden sind und daß jeder Kontaktstift (16, 18) mittels eines Brückensteckers (20) mit seinem zugeordneten Buskontaktstift (12, 14) elektrisch leitend verbindbar ist.

2. Rückwandleiterplatte (2) nach Anspruch 1 mit wenigstens zwei Bussen (26, 28), wobei die Busse (26, 28) jeweils aus mehreren Busleitungen (30, 32) bestehen, **dadurch gekennzeichnet**, daß die Buskontaktstifte (12, 14) jeder Federleiste (6) eines Busses (26, 28) mittels vielpoliger Brückenstecker (20) mit den korrespondierenden Kontakten (16, 18) verbindbar sind.

## Claims

1. A backplane printed circuit board (2) with several socket connectors (6) arranged in parallel, side by side on the side (4) that faces the modules, the contact pins (8) of which connectors form a pin field on the side (10) that faces away from the modules, and with at least one bus (26, 28), which consists of at least one bus line (30, 32),
characterised in that
allocated to a bus contact pin (12, 14) of each socket connector (6) of a bus (26, 28) there is a contact pin (16, 18), in that these contact pins (16, 18) are connected to each other in an electrically conducting manner by means of the bus line (30, 32) and in that each contact pin (16, 18) is able to be connected in an electrically conducting manner by means of a jumper plug (20) to its associated bus contact pin (12, 14).

2. A backplane printed circuit board (2) according to claim 1, with at least two buses (26, 28), wherein the buses (26, 28) consist in each case of several bus lines (30, 32), characterised in that the bus contact pins (12, 14) of each socket connector (6) of a bus (26, 28) are able to be connected by means of multi-pole jumper plugs (20) with the corresponding contacts (16, 18).

## Revendications

1. Plaquette à circuits imprimés de paroi arrière (2), comportant plusieurs barrettes à ressorts (6), qui sont disposées parallèlement côte-à-côte sur la face (4), tournée vers les modules et dont les broches de contact (8) forment, sur la face (10) tournée à l'opposé des modules, un panneau de pointes, et comportant au moins un bus (26, 28), qui possède au moins une ligne (30, 32), caractérisée par le fait qu'une broche de contact (16, 18) est associée à une broche de contact de bus (12, 14) de chaque barrette à ressorts (6) d'un bus (26, 28), que ces broches (16, 18) sont reliées entre elles d'une manière électriquement conductrice à l'aide de la ligne de bus (30, 32) et que chaque broche de contact (16, 18), peut être raccordée d'une manière électriquement conductrice, au moyen d'un connecteur en pont (20), à la broche de contact de bus (12, 14), qui lui est associée.

2. Plaquette à circuits imprimés de paroi arrière (2) suivant la revendication 1, comportant au moins deux bus (26, 28) constitués chacun par plusieurs lignes (30, 32), caractérisée par le fait que les broches de contact de bus (12, 14) de chaque barrette à ressorts (6) d'un bus (26, 28) peuvent être raccordées au moyen de connecteurs en pont multipolaires (20) possédant les contacts correspondants (20) possédant les contacts correspondants (16, 18).

FIG 1

FIG 2